# EUROPEAN PATENT APPLICATION

(11) **EP 4 421 709 A1**
(43) Date of publication of application: **28.08.2024**
(21) Application number: 23157917.8
(22) Date of filing: 22.02.2023
(51) Int. Cl.: G06Q 10/30

(54) **METHOD OF GENERATING AN INDUSTRIAL ELECTRICAL PRODUCT DISASSEMBLY ROUTINE**

(71) Applicant: Siemens Aktiengesellschaft, 80333 München (DE)
(72) Inventor: Agha, Imran, Manchester M11 4TE (GB); Hulley, Mark, Sheffield S8 9HA (GB); Moody, Robert, Knutsford WA16 8DE (GB); Ng, Jia Hua, Sheffield S10 2GJ (GB)
(74) Representative: Siemens Patent Attorneys

(57) **Abstract**

A computer-implemented method of generating an industrial electrical product disassembly routine script to be executed by an automated device is described. Firstly, an industrial electrical product and its constituent individual components are identified. Then, a computer-aided design (CAD) model of the industrial electrical product and its individual components is retrieved. The CAD model contains, for each individual component, metadata indicating positional data for the individual component and describing requirements for disassembling the individual component from the industrial electrical product. Finally, for each identified individual component generating a file readable by an automated device from the metadata, the file comprising instructions to be executed by the automated device as a disassembly script to disassemble the industrial electrical product.

## Description

The present invention relates to a computer-implemented method of generating an industrial electrical product disassembly routine script to be executed by an automated device, and an automated method of disassembling an industrial electrical product.

Sustainability is of increasing focus in relation to both sourcing of and disposing of industrial electrical products. This broadly covers the environmental, economic and soci-etal factors in materials usage, particularly around recycling and reuse of electronic materials and components. When an industrial electrical product, such as an electric motor, drive or controller approaches its end of life it is typically disposed of without any targeted disassembly or automated processing for reuse. This may be at e-waste facilities or even landfill. One exception to this is the Apple^{™} Material Recovery Lab, where the Daisy robot dismantles used Apple^{™} devices to recover components for materials recycling. However, such programs are not widespread, and at present cover only a small geographical area and product line.

Recent legislation in the European Union (Directive (EU) 2019/771) provides consumers with a right to repair during the guarantee period of a product, and forms part of the EU-wide drive for a circular economy and the use of repairable technologies. This will, over time, lead to an increase in demand for automated repair, disassembly for refurbishment or correct disposal of industrial electrical products. Individual components and entire products will need to be available for re-use, whether these are obtained from recyclers, waste companies or customers. Targeted disassembly would enable specific materials, such as plastics and metals/alloys, to be recycled and used in new components, as well as components to be maintained or refurbished for reuse.

Currently, no system exists that enables targeted disassembly of industrial electrical products such as motors, drives or controllers. Although automation using robots can be trained to disassemble small number of items (such as the Apple^{™} Daisy system), doing so for a wide variety of industrial electrical products has yet to be achieved. As a simple example, controllers may come in a wide variety of enclosures with slightly differing screw positions. In addition, such robots work on the principle that materials are recovered for recycling, whereas the condition of such materials or the components they are found in is not assessed. In other words, there is no provision to determine whether or not such materials or components could be re-used *as is,* or refurbished. There therefore exists a need, particularly for industrial electrical products, for automated industrial electrical product condition monitoring system and automated disassembly methods.

As part of this automation process, a robot needs to be able to find components quickly and easily, and to be able to select the correct tool to remove items such as screws and fasteners. This is relatively simple during automated assembly, since typically a robot is building to a single build specification. But during disassembly, a robot may be presented with many different industrial electrical products, or variations within single builds. Even if a robot is assigned to disassemble a single build for a specific industrial electrical product, the issue of component placement still remains. Within each industrial electrical products, the positioning of individual components may vary as a result of any manufacturing tolerance, thus requiring a degree of tolerance acceptance during disassembly. These factors lead to any automation of disassembly requiring a large number of scripts to be available at any one time, with the ability to use real-world data to customise such scripts also being a consideration. Consequently, for automated disassembly to work successfully, there is a need to be able to generate disassembly scripts simply, easily, quickly and accurately.

The embodiments of the present invention aim to address these issues by providing a computer-implemented method of generating an industrial electrical product disassembly routine script to be executed by an automated device, the method comprising the steps of: a) identifying an industrial electrical product and its constituent individual components; b) retrieving a computer-aided design (CAD) model of the industrial electrical product and its individual components, wherein the CAD model contains, for each individual component, metadata indicating positional data for the individual component and describing requirements for disassembling the individual component from the industrial electrical product; c) for each identified individual component generating a file readable by an automated device from the metadata, the file comprising instructions to be executed by the automated device as a disassembly script to disassemble the industrial electrical product.

By annotating individual components with a CAD model of an industrial electrical product with data regarding position and tools, disassembly scripts can be generated easily and accurately to enable efficient automated disassembly of the industrial electrical product, optimised around reduced resource and increased automation. This opens up a wide range of industrial electrical products to reuse, recycling, refurbishment or disposal, as required.

The file may be generated online as part of an industrial electrical product disassembly routine. Alternatively, the file may be generated offline prior to execution of an industrial electrical product disassembly routine.

Preferably, the step of deriving positional data comprises mapping the co-ordinate system of the individual component to the absolute origin of the co-ordinate system of the industrial electrical product.

Preferably, the step of mapping the co-ordinate system of the individual component to the absolute origin of the co-ordinate system of the industrial electrical product comprises determining a distance in three-dimensional co-ordinates and a rotation matrix.

Preferably, the step of deriving positional data further comprises mapping the real-world co-ordinates of the automated device to the co-ordinate system of the industrial electrical product.

Preferably, the requirements for disassembling the individual component from the industrial electrical product comprise data identifying the tools and respective tool settings and usage instructions required by the automated device to disassemble the individual component from the industrial electrical product.

Preferably, the method further comprises the step of mapping the co-ordinate system of a tool to the co-ordinate system of a flange adapted to receive the tool mounted on the automated device.

Preferably, the method further comprises collating files for each individual component to be disassembled from the industrial electrical device in a single executable application.

Preferably, the file further comprises a correction factor for each co-ordinate system to take into account discrepancies between a real-world co-ordinate system in an automated device cell and the absolute origin of the CAD model.

Preferably, the method further comprises the step of inspecting the industrial electrical product to derive observed positional data for the identified individual components to confirm or correct the positional data indicated in the metadata.

In a second aspect, embodiments of the present invention provide a computer program product comprising instructions, which, when the program is executed on a computer, cause the computer to carry out the steps of the method outlined above.

In a third aspect, embodiments of the present invention provide an automated method of disassembling an industrial electrical product, comprising: a) identifying an industrial electrical product and its constituent individual components; b) identifying, from a computer-aided design (CAD) model of the industrial electrical product, a plurality of individual components, wherein the CAD model contains, for each individual component, metadata indicating positional data for the individual component and describing requirements for disassembling the individual component from the industrial electrical product; c) for each identified individual component, generating a file readable by an automated device from the metadata, the file comprising instructions to be executed by the automated device as a disassembly script to disassemble the industrial electrical product; d) outputting the file to an automated device; and e) disassembling the industrial electrical product using the automated device.

The file may be generated online as part of the disassembly of the industrial electrical product. Alternatively, the file may be generated offline prior to disassembly of the industrial electrical product.

The present invention will now be described by way of example only, and with reference to the accompanying drawings, in which:
Figure 1 is a schematic illustration of an automated industrial electrical product disassembly system in accordance with the embodiments of the present invention;
Figure 2 is a flowchart outlining the steps in a method in accordance with the embodiments of the present invention;
Figure 3 is an image of a perspective view of a screw within a CAD model;
Figure 4 is a schematic illustration of mapping co-ordinate systems in the embodiments of the present invention;
Figure 5 is an example of the output from the execution of a batch executable application file in accordance with embodiments of the present invention;
Figure 6 is a photograph of an automated industrial electrical product disassembly system in accordance with the embodiments of the present invention; and
Figure 7 is a flowchart illustrating a method in accordance with the embodiments of the present invention.

Embodiments of the present invention take the approach that annotating the original CAD (Computer-Aided Design) model of an industrial electrical product with metadata relating to the individual components of the industrial electrical product enables the automatic generation of disassembly scripts. Embodiments of the present invention offer a computer-implemented method of generating the industrial electrical product disassembly routine. This is executed by an automated device, such as a robot. Initially, the method identifies an industrial electrical product and its constituent individual components. Next, a computer-aided design (CAD) model of the industrial electrical product and its individual components is retrieved, typically from data storage that may be either local or remote, such as cloud-based storage. The CAD model contains, for each component, metadata indicating positional data for the component and describing requirements for disassembling the component from the industrial electrical product. Then, for each identified component a file that is readable by an automated device is generated from the metadata. This file comprises instructions to be executed by the automated device to disassemble the industrial electrical product.

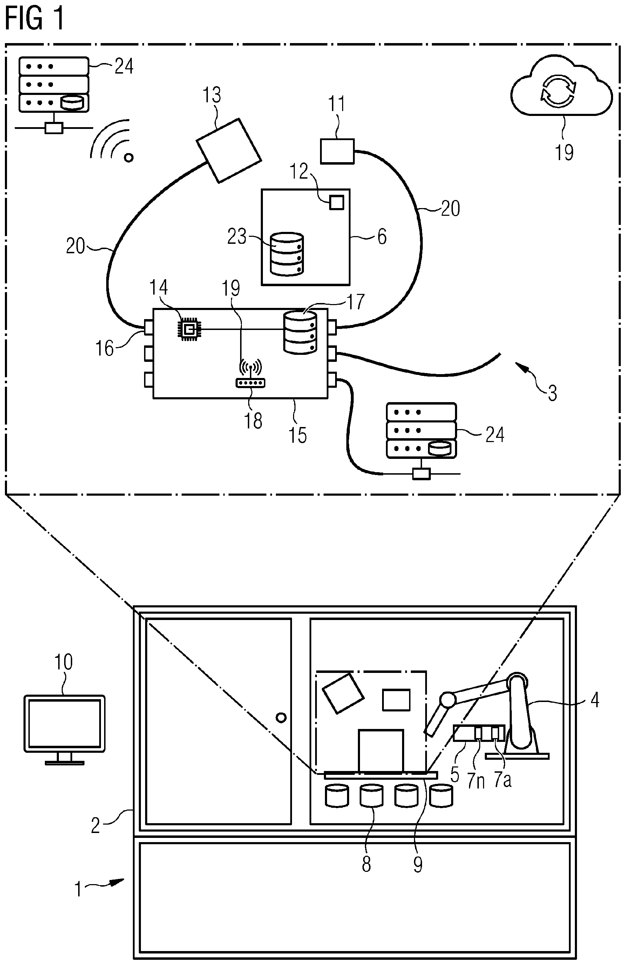

Figure 1 is a schematic illustration of an automated industrial electrical product disassembly system in accordance with the embodiments of the present invention. The automated disassembly system 1 comprises a cell 2 that houses an automated industrial electrical product condition monitoring system 3, along with an automated device 4, such as a robot, and a tool rack 5. The automated device 4 is positioned within the cell 2 to receive an industrial electrical product 6, and the tool rack 5 is provided to hold the tools 7a...n that the automated device 4 will need to disassemble the industrial electrical product 6. A number of bins 8 are placed adjacent a platform 9 on which the automated device 4 sits, in order to receive components removed from the industrial electrical product 6 by the automated device 4 during disassembly. The contents of these bins 8 are then either reused, recycled, refurbished or disposed of as required. A user display 10 is provided outside of the cell 2 to enable a user to interrogate the condition of the industrial electrical product 6 and monitor its disassembly. An automated industrial electrical product condition monitoring system 3, also shown in an exploded view, comprises a data input device 11 that is adapted to read a digital identity credential 12 affixed to the industrial electrical product 6. An inspection device 13 is positioned to be able to inspect the physical characteristics of the industrial electrical product 6, with both the data input device 11 and the inspection device 13 being connected to a processor 14 within a housing 15, which is also provided with a number of I/O ports 16, a storage device 17, a wireless adapter 18 (this may be omitted depending upon the method used to inspect the industrial electrical product 6) and a main data bus 19 connecting the various components together. In this example, the data input device 11 and the inspection device 13 are physically connected to the processor 14 by means of a data bus 20, but may alternatively be connected wirelessly using the wireless adapter 18. In this embodiment, a data output device 21 is provided in the form of a data bus 22, but may also alternatively be the wireless adapter 18.

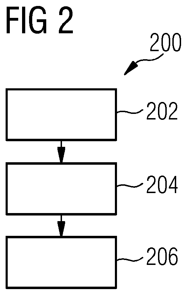

Figure 2 is a flowchart outlining the steps in a method in accordance with the embodiments of the present invention. The method 200 of generating an industrial electrical product disassembly routine script to be executed by an automated device 4 begins with, at step 202, identifying an industrial electrical product and its constituent individual components. This may be done in a two ways, depending on whether CAD data for the industrial electrical product 6 is retrieved at the point the industrial electrical product 6 is identified and enters the cell 2 (online), or whether the disassembly script is accessed having been generated prior to the industrial electrical product 6 entering the cell 2 (offline). For online generation, the industrial electrical product 6 may be identified in a number of ways, for example, by using the inspection device 13, which may be an optical device, such as a camera, or by reading the digital identity credential 12, which may be optically readable or electronically readable, such as 1-D barcode, 2-D matrix code or OR code, a character string, an image, an RFID (radio-frequency ID) device or NFC (near-field communication) device. Where the digital identity credential 12 is electronically readable, the data input device 11 is provided with the relevant capabilities to be able to read the digital identity credential 12. The digital identity credential 12 stores unique identification data for the industrial electrical product 6, such as a serial number, which is stored in a read-only format. The processor 14 identifies the industrial electrical product 6 based on the digital identity credential 12 read by the data input device 11. It also searches for status information relating to the industrial electrical product and retrieves the status information for further processing. As outlined above, this data may be held in a data store 23 housed within the industrial electrical product 6 or in a database 24, remote from the industrial electrical product in which status data is stored by digital identity credential. For offline generation, the industrial electrical product 6 may be identified by selecting a product name, serial number or other identifier available to a computer separate to the cell 2 set-up.

Once identified, the method moves to step 204, where the processor 14 retrieves a computer-aided design (CAD) model of the industrial electrical product 6 and its individual components 25. The CAD model may be stored in the data store 23 housed within the industrial electrical product 6 or within the remote database 24. The CAD model contains, for each component 25, metadata indicating positional data for the component 25 and describing requirements for disassembling the component 25 from the industrial electrical product 6. This is explained further below. Finally, at step 206, for each identified component 25 a file readable by the automated device 4 is generated from the metadata. This file comprises instructions to be executed by the automated device 4 to disassemble the industrial electrical product 6.

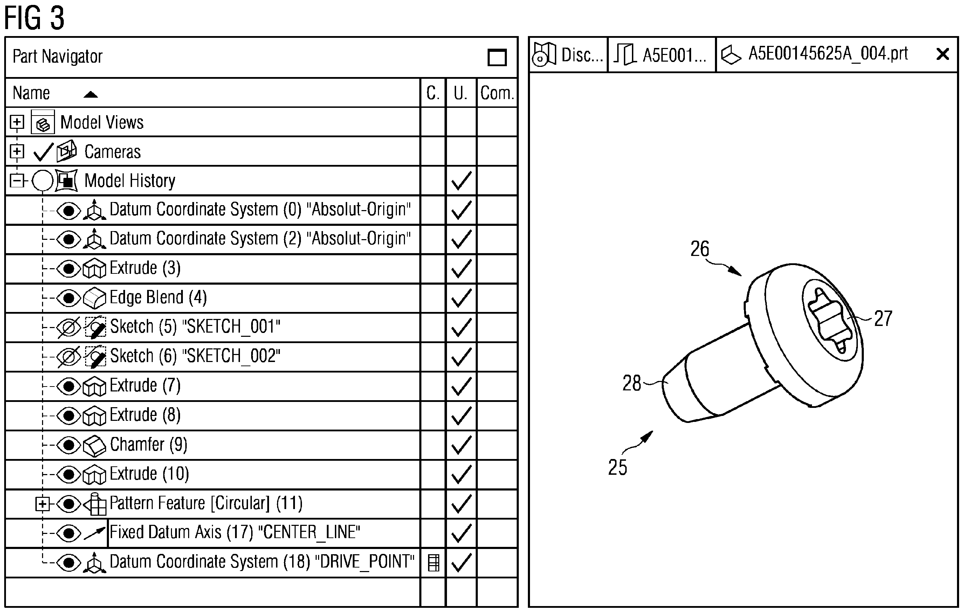

In order to generate the metadata required for the disassembly routine script, the embodiments of the present invention take into account both positional data connected with the position of the individual components and data connected with the identity of the individual components. The positional data requires a knowledge of the co-ordinate system of the individual component 25, the co-ordinate system of the industrial electrical product 6 and the real-world co-ordinates of the automated device 4. Within a CAD model each individual component within the model will have its own local co-ordinate system. This is usually based around a face or vertex of the individual component, and is illustrated in Figure 3. Figure 3 is an image of a perspective view of a screw within a CAD model. The screw 26 is shown in three-dimensions, with the x- and z- axes lying in a plane defined by the head 27 of the screw (as indicated by the star-shaped indent formed from two Robertson squares), and the *y*-axis lying along the centre of the shaft 28. A fixed datum axis A lies along the *y*-axis, forming a centre line of the screw 26. The position of the screw 26 within an industrial electrical product 6 is located using the co-ordinate system of the CAD model, with the local co-ordinate system of the screw 26 being related to the absolute origin of the CAD model, which also provides a fixed datum. Initially, therefore, to determine the positional data of the screw 26, the co-ordinate system of the screw 26 must be mapped to the absolute origin of the co-ordinate system of the industrial electrical product 6. This is done by determining a distance in three-dimensional co-ordinates and a rotation matrix, such that the co-ordinate system of the screw 26 can be transformed to the absolute origin of the industrial electrical product 6 co-ordinate system.

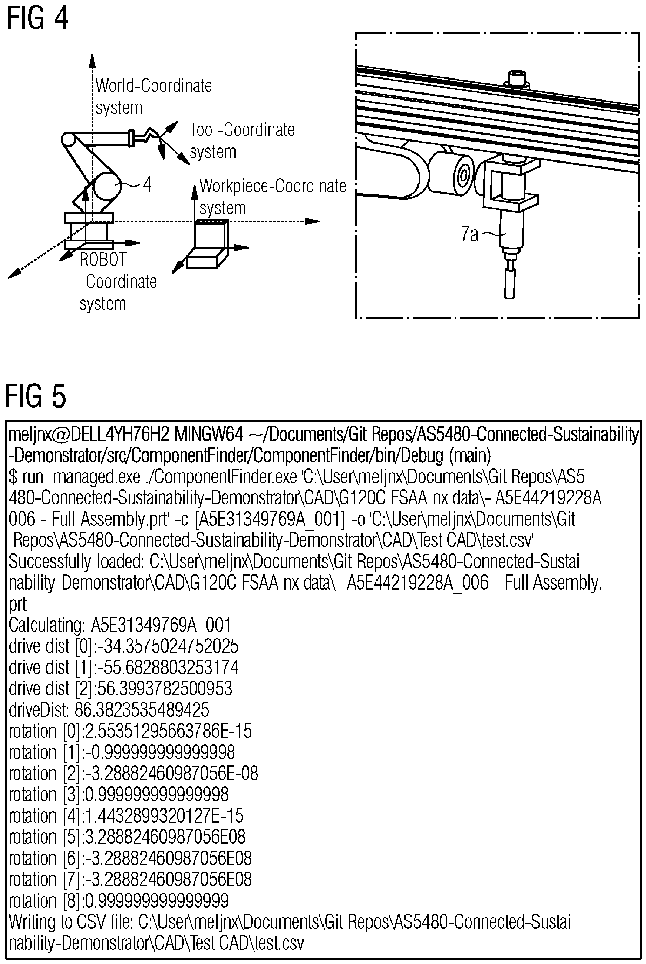

In order for the automated device 4 to be able to locate an individual component 25 such as the screw 26, the next step is to map the real-world co-ordinates of the automated device to the co-ordinate system of the industrial electrical product 6. Finally, since the automated device 6 will remove the screw 26 from the industrial electrical product 6 using a tool 7a, a flange adapted to receive the tools 7a...n is provided on the automated device 6. The last step in determining the positional data is therefore mapping the co-ordinate system of a tool to the co-ordinate system of a flange adapted to receive the tool mounted on the automated device. Each of these mappings generates a transformation, each of which are combined to enable the tool 7a to engage with head 27 of the screw 26. This is shown in more detail in Figure 4, which is a schematic illustration of mapping co-ordinate systems in the embodiments of the present invention.

In addition to positional data, the requirements for disassembling the individual component 25 from the industrial electrical product 6 comprises data identifying the tools 7a...n and respective tool settings and usage instructions required by the automated device 4 to disassemble the individual component 25 from the industrial electrical product 6. These instructions and tool information may be held in a database, which may be the same database 24 as the CAD model of the industrial electrical product 6.

Once all of the positional data and data relating to identifying tools and respective tool settings has been gathered, this can be stored as metadata within the CAD model for each individual component 25 in the industrial electrical product 6. The line in the CAD model corresponding to each individual component 25 is annotated with the gathered data, and then used as the basis for the disassembly script generation. For example, the datum shown in Figure 3 provides positional data, and is included as a line in the model of the screw 26. The individual components 25 may be identified by name within the model, and the name matched to attributes such as the screw head shape and thread either in an additional line of description associated with the screw or as a link to a library within the CAD model. Individual component 25 attribute data may be included as PMI data (Product and Manufacturing Data) within the original CAD model of the electrical product 6, and utilised along with additional positional data as the metadata in accordance with the embodiments of the present invention. PMI data may be used to include any details required to be able to create the disassembly script. Generating the file from the metadata enables the creation of a disassembly script in a format such as a CSV file to be sent to the automated device 4 to carry out the disassembly of the industrial electrical product 6. This involves collating the files for each individual component 25 to be disassembled from the industrial electrical device 6 in a single executable application. It may also be necessary to include a correction factor for each co-ordinate system to take into account discrepancies between a real-world co-ordinate system in the automated device cell 2 and the absolute origin of the CAD model. This may be done in advance, offline, if the identity of the cell 2 and automated device 4 are known, since this may include information on the cell 2 co-ordinates, or online once the industrial electrical product 6 has been loaded into the cell 2 and the CAD model accessed. As a check, before the disassembly script is run, the industrial electrical product 6 may be inspected to derive observed positional data for the identified individual components 25 to confirm or correct the positional data indicated in the metadata. This is done ideally by the inspection device 13 within the cell 2. At this point, should any discrepancies be identified, the disassembly script may be corrected.

An example of an output disassembly script for the screw 26 described above is given below:
A5E46033268A_001 (M4 x14 Plastite Screw)
Drive dist [0]:25.4
Drive dist [1]:155.195
Drive dist [2]:129.34
driveDist:203.616020059818

The screw 26 ("M4 x14 Plastite Screw") is clearly identified, along with its size ("M4"), which enables the automated device 6 to select the correct tool 7a to remove the screw 26. The position of the screw 26 is then given in terms of the distance the automated device 6 will need to move the tool 7a to access the screw 26. Figure 5 is an example of a batch executable application file generated in accordance with embodiments of the present invention. The batch application file may be called from a command line interface (CLI), which enables the automation of the individual disassembly scripts for each individual component 25 within the industrial electrical product 6.

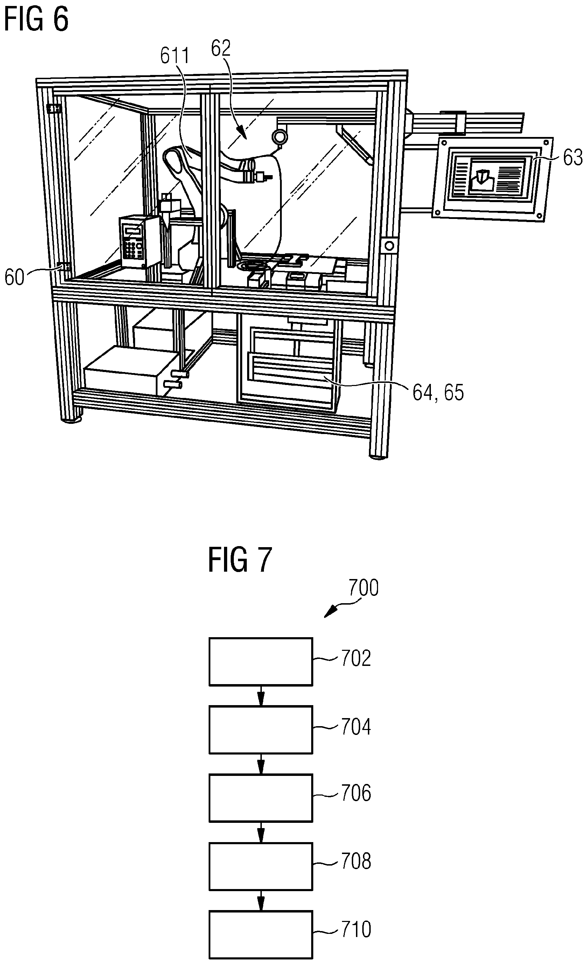

An example of the disassembly of an industrial electrical product 6 using the disassembly scripts of the embodiments of the present invention will now be described. Figure 6 is a photograph of an automated industrial electrical product disassembly system in accordance with the embodiments of the present invention. The cell 60 contains both the automated device 61, which in this case was a robot, and an automated industrial electrical product (not shown) condition monitoring system 62. A user display 63 is also mounted outside of the cell 60. The processor 64 and associated components were provided in the form of a PC on which the disassembly scripts and CAD models were run. A controller 65 for the automated device 61 is mounted under the cell 60. In order to assess the system and methods of the embodiments of the present invention, a SINAMICS G120 Inverter (available at www.siemens.com) was chosen for automated disassembly. Siemens NX CAD models were used along with data available from existing PLM databases. A vision inspection system, available from Cognex (www.cognex.com/en-gb), was used as the inspection device 13. In this example, the file containing the metadata was generated offline, and a CSV script was generated in order for the automated device 4 to disassemble the industrial electrical product 6. When executed by the automated device 61 the disassembly scripts caused the correct removal of a number of selected individual components (not shown in this view), which were sorted into the correct bins for reuse, recycling, refurbishing or disposal, as required.

The steps of this method are outlined in Figure 7, which is a flowchart illustrating a method in accordance with the embodiments of the present invention. The method 700 of disassembling an industrial electrical product 62 begins with, at step 702, identifying an industrial electrical product and its constituent individual components 67. As described above, this may be done in a two ways, depending on whether CAD data for the industrial electrical product 62 is retrieved at the point the industrial electrical product 62 is identified and enters the cell 60 (online), or whether the disassembly script is accessed having been generated prior to the industrial electrical product 62 entering the cell 60 (offline). Once identified, the method moves to step 704, where the processor 65 retrieves a computer-aided design (CAD) model of the industrial electrical product 61 and its individual components 67. The CAD model may be stored in the data store 68 housed within the industrial electrical product 62 or within the remote database 69. The CAD model contains, for each component 67, metadata indicating positional data for the component 67 and describing requirements for disassembling the component 67 from the industrial electrical product 62. This is explained further below. At step 706, for each identified component 67 a file readable by the automated device 61 is generated from the metadata. This file comprises instructions to be executed by the automated device 61 to disassemble the industrial electrical product 62. At step 708, a disassembly script is generated from the file and output to the automated device 61. Finally, at step 710, the industrial electrical product 62 is disassembled using the automated device 61.

The standard approach for programming routines for automated assembly systems has been to manually teach the routines at the machine. CAM / CAD models have been used for some time in applications such as machining and more recently for programming of systems like robots. As targeted disassembly within the industrial sector becomes more widespread, the embodiments of the present invention offer a simple, accurate, effective and low resource solution to generating the executable code required for the disassembly of a wide range of industrial electrical products. Whilst the example of an inverter is given above, it should be understood that the term "industrial electrical product" encompasses a wide range of electrical items, including, but not limited to, converters, inverters, motors, drives, generators, controllers and devices used in industrial automation processes. Whilst the embodiments of the invention described above utilise a computer program to generate disassembly scripts, the embodiments may also be implemented using alternative generation means, such as a server with the capability to process multiple devices or an loT (Internet of Things) device that is connected to the cell 2. In this specification, independent of the grammatical term usage, individuals with male, female or other gender identities are included within the term.

## Claims

1. A computer-implemented method of generating an industrial electrical product disassembly routine script to be executed by an automated device, **characterised in that** the method comprising the steps of:
a) identifying an industrial electrical product and its constituent individual components;
b) retrieving a computer-aided design (CAD) model of the industrial electrical product and its individual components, wherein the CAD model contains, for each individual component, metadata indicating positional data for the individual component and describing requirements for disassembling the individual component from the industrial electrical product;
c) for each identified individual component generating a file readable by an automated device from the metadata, the file comprising instructions to be executed by the automated device as a disassembly script to disassemble the industrial electrical product.

2. Computer-implemented method as claimed in claim 1, wherein the file is generated online as part of an industrial electrical product disassembly routine.

3. Computer-implemented method as claimed in claim 1, wherein the file is generated offline prior to execution of an industrial electrical product disassembly routine.

4. Computer-implemented method as claimed in any of claims 1, 2 or 3, wherein the step of deriving positional data comprises:
mapping the co-ordinate system of the individual component to the absolute origin of the co-ordinate system of the industrial electrical product.

5. Computer-implemented method as claimed in claim 4, wherein the step of mapping the co-ordinate system of the individual component to the absolute origin of the co-ordinate system of the industrial electrical product comprises determining a distance in three-dimensional co-ordinates and a rotation matrix.

6. Computer-implemented method as claimed in claim 4, wherein the step of deriving positional data further comprises:
mapping the real-world co-ordinates of the automated device to the co-ordinate system of the industrial electrical product.

7. Computer-implemented method as claimed in claim 4, wherein the requirements for disassembling the individual component from the industrial electrical product comprises data identifying the tools and respective tool settings and usage instructions required by the automated device to disassemble the individual component from the industrial electrical product.

8. Computer-implemented method as claimed in claim 4, wherein the method further comprises the step of:
mapping the co-ordinate system of a tool to the co-ordinate system of a flange adapted to receive the tool mounted on the automated device.

9. Computer-implemented method as claimed in claim 6, further comprising collating files for each individual component to be disassembled from the industrial electrical device in a single executable application.

10. Computer-implemented method as claimed in claim 6, wherein the file further comprises a correction factor for each co-ordinate system to take into account discrepancies between a real-world co-ordinate system in an automated device cell and the absolute origin of the CAD model.

11. Computer-implemented method as claimed in claim 1, further comprising the step of inspecting the industrial electrical product to derive observed positional data for the identified individual components to confirm or correct the positional data indicated in the metadata.

12. A computer program product comprising instructions, which, when the program is executed on a computer, cause the computer to carry out the steps of any of claims 1 to 11.

13. An automated method of disassembling an industrial electrical product, **characterised in that** the method comprises the steps of:
a) identifying an industrial electrical product and its constituent individual components;
b) identifying, from a computer-aided design (CAD) model of the industrial electrical product, a plurality of individual components, wherein the CAD model contains, for each individual component, metadata indicating positional data for the individual component and describing requirements for disassembling the individual component from the industrial electrical product;
c) for each identified individual component, generating a file readable by an automated device from the metadata, the file comprising instructions to be executed by the automated device as a disassembly script to disassemble the industrial electrical product;
d) outputting the file to an automated device; and
e) disassembling the industrial electrical product using the automated device.

14. Automated method as claimed in claim 13, wherein the file is generated online as part of the disassembly of the industrial electrical product.

15. Automated method as claimed in claim 13, wherein the file is generated offline prior to disassembly of the industrial electrical product.
